# EUROPEAN PATENT APPLICATION

(11) **EP 2 207 235 A1**
(43) Date of publication of application: **14.07.2010**
(21) Application number: 08834384.3
(22) Date of filing: 15.08.2008
(51) Int. Cl.: H01M 10/44, H01M 2/10, H01M 10/48, H01M 16/00, H02J 7/02

(54) **POWER SUPPLY SYSTEM AND CELL ASSEMBLY CONTROL METHOD**

(30) Priority: 25.09.2007 JP 2007247046
(71) Applicant: Panasonic Corporation, Kadoma-shi Osaka 571-8501 (JP)
(72) Inventor: SUGIYAMA Shigeyuki C/o Panasonic Corporation, Chuo-ku, Osaka-shi Osaka 540-6207 (JP); AOKI Mamoru C/o Panasonic Corporation, Chuo-ku, Osaka-shi Osaka 540-6207 (JP); SUZUKI Kohei C/o Panasonic Corporation, Chuo-ku, Osaka-shi Osaka 540-6207 (JP)
(74) Representative: Schwabe - Sandmair - Marx
(86) International application number: PCT/JP2008/002222
(87) International publication number: WO 2009/040980

(57) **Abstract**

The power supply system of the present invention includes: a cell assembly in which a first assembled battery, formed from a plurality of first cells connected in series, and a second assembled battery, formed from a plurality of second cells connected in series, are connected in parallel; and a generator for charging the cell assembly. The cell assembly is configured such that an average charging voltage V1 as a terminal voltage when the first assembled battery reaches a charging capacity that is half of a full charge capacity is set to be a voltage that is smaller than an average charging voltage V2 as a terminal voltage when the second assembled battery reaches a charging capacity that is half of a full charge capacity.

## Description

### Technical Field

The present invention relates to a power supply system made up of a cell assembly in which a plurality of cells are combined, and a method of controlling such a cell assembly, and more specifically relates to technology of causing the cell assembly to function as a power source without overcharging the cell as a secondary battery.

### Background Art

An alkaline storage battery such as a nickel hydride storage battery and a nickel cadmium storage battery, and a nonaqueous electrolyte secondary battery such as a lithium ion secondary battery and a lithium polymer secondary battery have higher energy density per unit weight than a lead storage battery, and are attracting attention as a power source to be mounted on mobile objects such as vehicles and portable devices. In particular, if cells made up of a plurality of nonaqueous electrolyte secondary batteries are connected in series to configure a cell assembly with high energy density per unit weight, and mounted on a vehicle as a cell starter power supply (so-called power source that is not a drive source of the vehicle) in substitute for a lead storage battery, it is considered to be promising for use in races and the like.

While a power source of vehicles is discharged with a large current as a cell starter during the start-up on the one hand, it is charged by receiving the current sent from a generator (constant voltage charger) while the vehicle is being driven. Although the lead storage battery has a reaction mechanism that is suitable for charge/discharge with a relatively large current, it cannot be said that the foregoing secondary batteries are suitable for charge/discharge with a large current from the perspective of their reaction mechanism. Specifically, the foregoing secondary batteries have the following drawbacks at the end stage of charging.

Foremost, with an alkaline storage battery such as a nickel hydride storage battery or a nickel cadmium storage battery, oxygen gas is generated from the positive electrode at the end stage of charging, but when the atmospheric temperature becomes high, the charging voltage of the battery will drop pursuant to the drop in the voltage that generates oxygen gas from the positive electrode; that is, the oxygen overvoltage. If n-number of alkaline storage batteries in which the charging voltage of the batteries dropped to V₁ are to be charged with a constant voltage charger (rated charging voltage V₂) and the relation of V₂ > nV₁ is satisfied, the charge will not end and the oxygen gas will continue to be generated, and there is a possibility that the individual secondary batteries (cells) configuring the assembled battery will deform due to the rise in the inner pressure of the battery.

With a nonaqueous electrolyte secondary battery such as a lithium ion secondary battery or a lithium polymer secondary battery, while the electrolytic solution containing a nonaqueous electrolyte tends to decompose at the end stage of charging, this tendency becomes prominent when the atmospheric temperature increases, and there is a possibility that the cells configuring the assembled battery will deform due to the rise in the inner pressure of the battery.

In order to overcome the foregoing problems, as shown in Patent Document 1, it would be effective to pass additional current from a separate circuit (lateral flow circuit) at the time that the charge of the assembled battery to be used as the power source is complete.

When diverting Patent Document 1 to vehicle installation technology, the lateral flow circuit can be materialized as the following two modes. The first mode is the mode of configuring the lateral flow circuit in the form of supplying current to the other in-vehicle electrically powered equipment (lamp, car stereo, air conditioner and the like). The second mode is the mode of configuring the lateral flow circuit in the form of simply supplying current to a resistor that consumes current.

Nevertheless, when adopting the first mode, there is a possibility that the constant voltage charger will supply excessive current to the foregoing electrically powered equipment and cause the electrically powered equipment to malfunction. Moreover, when adopting the second mode, the heat that is generated when the resistor consumes the current will increase the atmospheric temperature of the foregoing secondary battery and the possibility of the cell deforming cannot be resolved. Thus, even if a secondary battery with high energy density per unit weight is randomly used to configure the cell assembly, it is difficult to combine it with a constant voltage charger.
Patent Document 1: Japanese Patent Application Laid-open No. H07-059266

### Disclosure of the Invention

An object of this invention is to provide a safe and secure power supply system that uses a secondary battery with high energy density per unit weight, and which is capable of inhibiting the deformation of such secondary battery even upon receiving all currents from a generator as a charging current.

In order to achieve the foregoing object, the power supply system according to one aspect of the present invention has: a cell assembly in which a first assembled battery, formed from a plurality of first cells connected in series, and a second assembled battery, formed from a plurality of second cells connected in series, are connected in parallel; and a generator for charging the cell assembly. The cell assembly is configured such that an average charging voltage V1 as a terminal voltage, when the first assembled battery reaches a charging capacity that is half of a full charge capacity, is set to be a voltage that is smaller than an average charging voltage V2 as a terminal voltage, when the second assembled battery reaches a charging capacity that is half of a full charge capacity.

In order to achieve the foregoing object, a control method of a cell assembly according to another aspect of the present invention is a method of controlling a cell assembly in which a first assembled battery, formed from a plurality of first cells connected in series, and a second assembled battery, formed from a plurality of second cells connected in series, are connected in parallel, and an average charging voltage V1 of the first assembled battery is set to be a voltage that is smaller than an average charging voltage V2 of the second assembled battery, the method comprising: a step (a) of measuring a voltage of the first assembled battery, and a step (b) of controlling so as to stop the charge to the first assembled battery when the voltage of the first assembled battery measured in the step (a) reaches an upper limit voltage Va.

According to the foregoing configuration, the present invention includes a cell assembly in which two types of assembled batteries, a first assembled battery, formed from a plurality of first cells connected in series, and a second assembled battery, formed from a plurality of second cells connected in series, are connected in parallel, and an average charging voltage V1 of the first assembled battery is set to be a voltage that is smaller than an average charging voltage V2 of the second assembled battery. Thereby, in a normal state (until reaching the forced discharge start voltage that is set to be slightly lower than the full charge voltage), the first assembled battery mainly receives the charging current from the generator, and, when the first assembled battery approaches full charge, the second assembled battery as the lateral flow circuit receives the charging current from the generator. According to this mode, since a resistor which is associated with excessive heat generation is not used, the atmospheric temperature of the cell assembly (particularly the first assembled battery as the primary power source) will not increase. Thus, it is possible to avoid the problem of the cell deforming due to heat.

Accordingly, even when using an alkaline storage battery such as a nickel hydride storage battery or a nickel cadmium storage battery or a nonaqueous electrolyte secondary battery such as a lithium ion secondary battery or a lithium polymer secondary battery with high energy density per unit weight as the secondary battery, it is possible to realize a safe and secure power supply system capable of receiving all currents from the generator as a charging current without inducing problems such as the deformation of the secondary battery.

Accordingly, in cases where it is necessary to constantly receive the charging current from the generator such as with a cell-starter power supply, the deformation of the secondary battery can be inhibited even if all currents from the generator are received as the charging current by adopting the power supply system of the present invention.

The present invention is particularly effective when using a cell starter power supply that needs to constantly receive a charging current from the generator.

The object, features and advantages of the present invention will become clearer based on the ensuing detailed explanation and attached drawings.

### Brief Description of the Drawings

[Fig. 1] Fig. 1 is a block diagram explaining the configuration of a power supply system according to an embodiment of the present invention.
[Fig. 2] Fig. 2 is a diagram showing the initial charge-discharge behavior of a lithium ion secondary battery as an example of a cell at a normal temperature.
[Fig.3] Fig. 3 is a functional block diagram of a power supply system according to an embodiment of the present invention.
[Fig. 4] Fig. 4 is a block diagram explaining the configuration of a power supply system according to another embodiment of the present invention.

### Best Mode for Carrying Out the Invention

The best mode for carrying out the present invention is now explained with reference to the attached drawings.

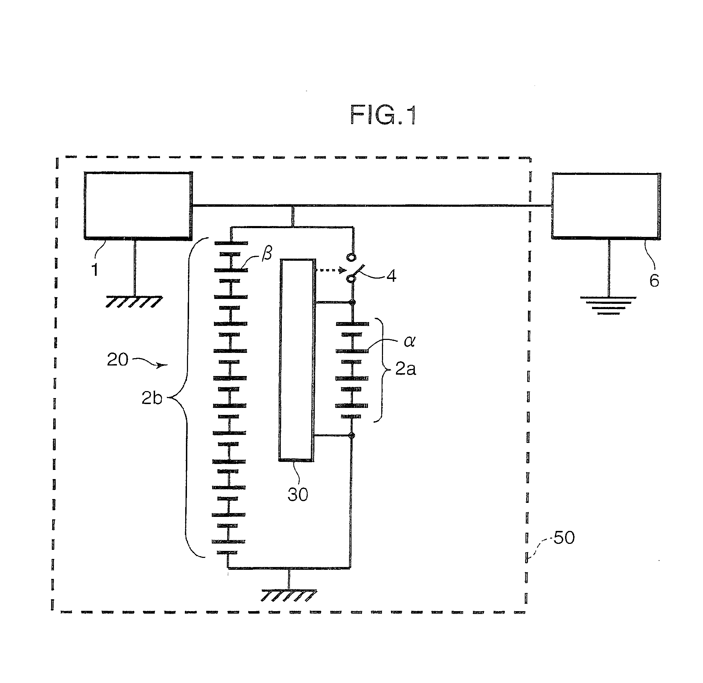

Fig. 1 is a block diagram explaining the configuration of a power supply system according to an embodiment of the present invention.

As shown in Fig. 1, the power supply system 50 comprises a generator 1, a cell assembly 20, and a control unit 30. The generator 1 is used for charging the cell assembly 20 and, for instance, is a generator that is mounted on a vehicle and having a constant voltage specification for generating power based on the rotary motion of the engine. The cell assembly 20 includes a first assembled battery 2a in which a plurality (four in the configuration of Fig. 1) of cells α (first cells) are connected in series and a second assembled battery 2b in which a plurality (twelve in the configuration of Fig. 1) of cells β (second cells) are connected in series, and the first assembled battery 2a and the second assembled battery 2b are connected in parallel. A charging current is randomly supplied from the generator 1 to the first assembled battery 2a and the second assembled battery 2b. Moreover, the parallel circuit of the cell assembly 20 is provided with a switch 4 for turning ON/OFF the connection between the generator 1 and the first assembled battery 2a based on a command from the control unit 30. Connected to the power supply system 50 is an in-car device 6 as an example of a load. The in-car device 6 is, for example, a load device such as a cell starter for starting the vehicle engine, lights, car navigation system or the like. The positive electrode of the first assembled battery 2a is connected to the in-car device 6, and the discharge current of the first assembled battery 2a is supplied to the in-car device 6.

Moreover, the voltage power terminal of the generator 1 is connected to the positive electrode of the second assembled battery 2b and the in-car device 6. In the foregoing case, when viewed from the generator 1, the cell assembly 20 and the in-car device 6 are connected in parallel. The voltage that is generated with the generator 1 is supplied in parallel to the cell assembly 20 and the in-car device 6.

A case of using a generator of a constant voltage specification as the generator 1 and a lithium ion secondary battery, which is an example of a nonaqueous electrolyte secondary battery, as the cell α configuring the first assembled battery 2a is now explained in detail.

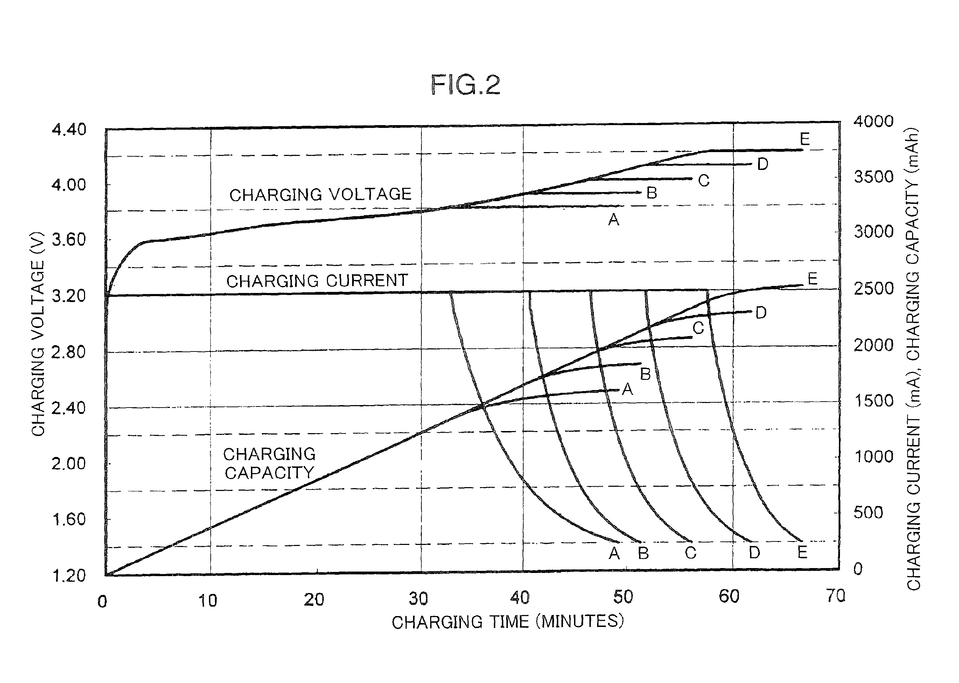

Fig. 2 is a diagram showing the charge behavior in the case of charging, with a generator of a constant voltage specification, a lithium ion secondary battery using lithium cobalt oxide as the positive electrode active material and using graphite as the negative electrode active material. In Fig. 2, a graph showing a case where the voltage Ve (terminal voltage of each cell) in which the rated voltage of the generator 1 is distributed per lithium ion battery (cell) is 3.8V is represented with symbol A, a graph showing a case of 3.9V is represented with symbol B, a graph showing a case of 4.0V is represented with symbol C, a graph showing a case of 4.1V is represented with symbol D, and a graph showing a case of 4.2V is represented with symbol E.

As shown in Fig. 2, in the case where the voltage Ve is 3.8V (shown with symbol A in Fig. 2), the current is constant from the charge start up to approximately 33 minutes, and the voltage is thereafter constant. In the case where the voltage Ve is 3.9V (shown with symbol B in Fig. 2), the current is constant from the charge start up to approximately 41 minutes, and the voltage is thereafter constant. In the case where the voltage Ve is 4.0V (shown with symbol C in Fig. 2), the current is constant from the charge start up to approximately 47 minutes, and the voltage is thereafter constant. In the case where the voltage Ve is 4.1V (shown with symbol D in Fig. 2), the current is constant from the charge start up to approximately 53 minutes, and the voltage is thereafter constant. In the case where the voltage Ve is 4.2V (shown with symbol E in Fig. 2), the current is constant from the charge start up to approximately 57 minutes, and the voltage is thereafter constant.

The generator 1 is configured so as to charge the cells α (lithium ion secondary battery) with a constant current until reaching the voltage Ve, and perform constant voltage charge to the lithium ion secondary battery while attenuating the current. For example, if the rated voltage is 3.9V (shown with symbol B in Fig. 2), the state of charge (SOC: State of Charge) (value obtained by dividing the charging capacity having a voltage Ve of 3.9V by the charging capacity having a voltage Ve of 4.2V) will be 73%. Meanwhile, if the voltage Ve of the generator 1 is 4.1V per lithium ion secondary battery (shown with symbol IV in Fig. 2), the SOC will be 91%. Table 1 show the relation between the rated voltage and the SOC based on Fig. 2.

**[Table 1]**

| | | | | | | | | | |
|---|---|---|---|---|---|---|---|---|---|
| Rated voltage (V) per cell | 4.2 | 4.15 | 4.1 | 4.05 | 4.0 | 3.95 | 3.9 | 3.85 | 3.8 |
| SOC (%) | 100 | 95.5 | 91 | 86.5 | 82 | 77.5 | 73 | 68.5 | 64 |

With the lithium ion secondary battery, when the SOC after charge approaches 100%, the component (primarily carbonate) of the electrolytic solution containing a nonaqueous electrolyte will easily decompose. Thus, in order to avoid a charging current from additionally being supplied from the generator 1 to the lithium ion secondary battery in a state where the SOC is close to 100%, the upper limit voltage Va is set to a range that is slightly lower than the voltage in which the SOC after the charge is near 100%.

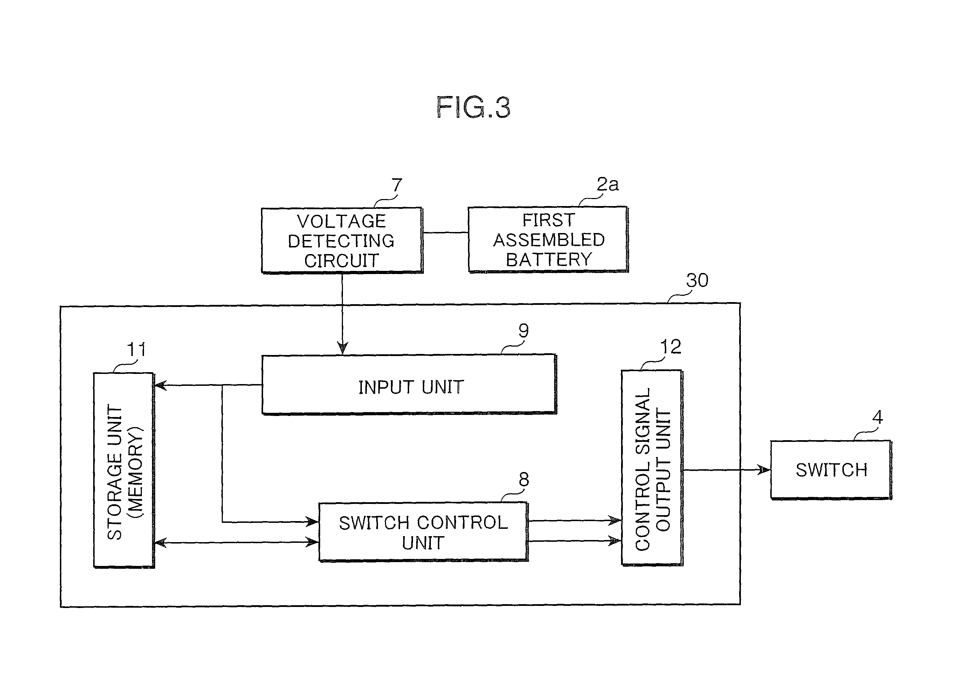

The specific operation of the power supply system 50 is now explained with reference to the functional block diagram of Fig. 3.

As shown with the functional block diagram of Fig. 3, the control unit 30 comprises an input unit 9 to which the voltage of the first assembled battery 2a measured with the voltage detecting circuit (voltage measurement unit) 7 is successively input, a storage unit (memory) 11 for storing the forced discharge start voltage Va of the first assembled battery 2a, a switch control unit 8 for switching the ON/OFF of the switch 4 connecting the generator 1 and the first assembled battery 2a based on the measured voltage input to the input unit 9 and the upper limit voltage Va read from the storage unit 11, and a control signal output unit 12 for outputting a control signal from the switch control unit 8 to the switch 4. The voltage detecting circuit 7 is configured, for example, using an AD (analog/digital) converter or a comparator for detecting the terminal voltage of the first assembled battery 2a.

When switch control unit 8 determines that the voltage of the first assembled battery 2a measured with the voltage detecting circuit 7 has reached the upper limit voltage Va read from the storage unit 11, it outputs a control signal to the switch 4 via the control signal output unit 12 for turning OFF the connection with the first assembled battery 2a. The connection of the generator 1 and the first assembled battery 2a is thereby turned OFF, and the supply of the charging current from the generator 1 to the first assembled battery 2a is stopped.

As described above, if the first assembled battery 2a reaches the upper limit voltage Va, the switch 4 is turned OFF based on a command from the control unit 30, and the supply of the charging current from the generator 1 to the first assembled battery 2a is stopped. As the switch 4, a general switch such as a field effect transistor (FET) or a semiconductor switch may be used.

Incidentally, a charging current is not constantly flowing from the generator 1 to the first assembled battery 2a or the second assembled battery 2b. For example, during braking or the like, the first assembled battery 2a and the second assembled battery 2b is contrarily discharged toward the in-car device 6, and enters a state of being able to receive the charging current from the generator 1 once again. The charging current flows to the second assembled battery 2b when the switch 4 is OFF, and preferentially flows to the first assembled battery 2a when the switch 4 is ON since the average charging voltage V1 is smaller than the average charging voltage V2 as described later. Thus, current will not be excessively supplied to the in-car device 8.

Although Fig. 3 shows a mode of the voltage detecting circuit 7 measuring the total voltage of the first assembled battery 2a, the configuration may also be such that the voltage detecting circuit 7 measures the voltage of the respective cells α configuring the first assembled battery 2a, and stops the charge to the first assembled battery 2a when the voltage of any one of the cells α configuring the first assembled battery 2a reaches the upper limit voltage Va.

When considering that the capacity of the cells α is not necessarily constant (for instance, due to the variation in the weight of the positive electrode active material or degree of deterioration caused by the difference in the temperature history), it can be said that the foregoing configuration is more preferable than the mode of Fig. 1.

Moreover, preferably, the ratio V2/V1 of the average charging voltage V1 of the first assembled battery 2a and the average charging voltage V2 of the second assembled battery 2b is set within the range of 1.01 or more and 1.18 or less. This is because, if the ratio V2/V1 is less than 1.01, the charging current from the generator 1 will easily flow to the second assembled battery 2b, and the first assembled battery 2a cannot be efficiently charged. Contrarily, if the ratio V2/V1 exceeds 1.18, the first assembled battery 2a will easily overcharge.

The method of calculating the average charging voltage is now explained.

If the cell is a nonaqueous electrolyte secondary battery such as a lithium ion secondary battery, the charge end voltage is manually set according to the characteristics of the active material that is used as the positive electrode or the negative electrode, but this is usually 4.2V. As shown in Fig. 2, in the case of E in Fig. 2 in which the charge end voltage is 4.2V, the full charge capacity is 2550mAh. Here, the voltage (3.8V) at the point in time that the charging capacity is 1275mAh (half the charging capacity when charging 4.2V) will be the average charging voltage per nonaqueous electrolyte secondary battery. Meanwhile, if the cell is an alkaline storage battery such as a nickel hydride storage battery, as the characteristics of nickel hydroxide as the positive electrode active material, the charging voltage will drop simultaneously with the completion of the full charge pursuant to the rise in temperature, and become a fully charged state. The voltage at the point in time of half the full charge capacity will be the average charging voltage of the alkaline storage battery.

For example, in the configuration of Fig. 1, if an alkaline storage battery (specifically, a nickel hydride storage battery having an average charging voltage of 1.4V per cell) is used as the cell β of the second assembled battery 2b, the average charging voltage V2 of the second assembled battery 2b made up of twelve cells β will be 16.8V. Meanwhile, the average charging voltage V1 of the first assembled battery 2a made up of four lithium ion secondary batteries (average charging voltage of 3.8V per cell) will be a value of (15.2V). Thus, the ratio V2/V1 of the average charging voltage V1 of the first assembled battery 2a and the average charging voltage V2 of the second assembled battery 2b will be 1.11. Under normal circumstances, since the generator 1 is of a constant voltage specification, as a result of setting the average charging voltage V1 of the first assembled battery 2a to be smaller than the average charging voltage V2 of the second assembled battery 2b as with the foregoing mode, it is possible to configure a safe and secure power supply system 50 that is able to receive all currents from the generator 1 as a charging current while inhibiting the deformation of the secondary battery without having to use any complicated means for transforming one of the assembled batteries (for example, means for causing the V2/V1 to become approximately 1.1 by using a DC/DC converter on one of the assembled batteries).

As the cell α configuring the first assembled battery 2a, preferably, a nonaqueous electrolyte secondary battery such as a lithium ion secondary battery is used as in this embodiment.

This is because the nonaqueous electrolyte secondary battery has high energy density in comparison to an alkaline storage battery, and is preferable as the receiving end of the charging current in the power supply system 50 of the present invention. Although a nonaqueous electrolyte secondary battery entails problems such as the electrolyte component decomposing under a high temperature environment, as a result of adopting the configuration of this embodiment in which a lateral flow circuit is used as the second assembled battery 2b in substitute for a resistor with significant heat generation, it is possible to prevent the problem of the cell deforming due to the rise in the atmospheric temperature of the cell assembly 20 (particularly the first assembled battery 2a as the primary power source). Thus, a nonaqueous electrolyte secondary battery with high energy density per unit weight can be used, without any problem, as the cell α configuring the first assembled battery 2a.

Moreover, when using a nonaqueous electrolyte secondary battery as the cell α, preferably, lithium composite oxide containing cobalt is used as the active material of the positive electrode of the nonaqueous electrolyte secondary battery.

This is because the discharge voltage of the nonaqueous electrolyte secondary battery can be increased as a result of using lithium composite oxide containing cobalt such as lithium cobalt oxide as the active material of the positive electrode, and the energy density can be easily increased.

Moreover, preferably, if the number of cells α to be detected by the voltage detecting circuit 7 in the first assembled battery 2a is n_{A}, the upper limit voltage Va of the first assembled battery 2a is set within the range of 4.05n_{A}V or more and 4.15n_{A}V or less. This is because, as evident from Fig. 2 and Table 1 that show the cells α, if the upper limit voltage Va is set to less than 4.05n_{A}V, the amount of charge acceptance of the first assembled battery 2a will be insufficient. Contrarily, if the upper limit voltage Va is set in excess of 4.15n_{A}V, the forced discharge of the first assembled battery 2a will not start until approaching the overcharge range of the cells α.

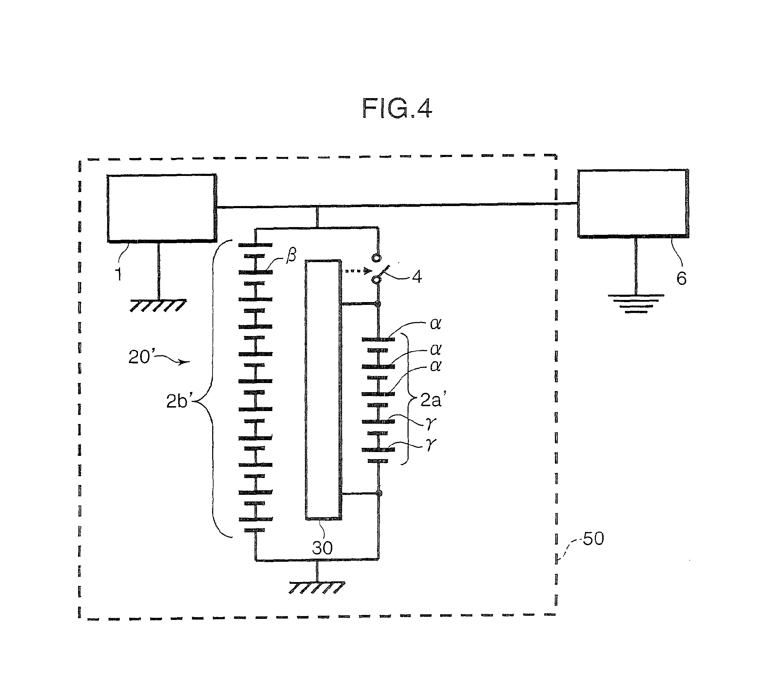

Fig. 4 shows another configuration example of the cell assembly according to this embodiment. As shown in Fig. 4, a cell assembly 20' is configured such that a first assembled battery 2a' and a second assembled battery 2b' are connected in parallel. The first assembled battery 2a' is configured by additionally connecting in series two alkaline storage batteries having an average charging voltage of 1.4V as the cells γ (third cells) to the three cells α, in which one cell α was reduced from the first assembled battery 2a in the configuration of the cell assembly 20 shown in Fig. 1, that are connected in series. The second assembled battery 2b' is configured such that eleven cells β, in which one cell β was reduced from the second assembled battery 2b in the configuration of the cell assembly 20 shown in Fig. 1, that are connected in series.

According to the foregoing configuration, the average charging voltage V1 of the first assembled battery 2a' will be 14.2V, and the average charging voltage V2 of the second assembled battery 2b' will be 15.4V. Consequently, the ratio V2/V1 of the average charging voltage V1 of the first assembled battery 2a' and the average charging voltage V2 of the second assembled battery 2b' can be set to be within the range of 1.01 or more and 1.18 or less. Here, preferably, the capacity of the cells γ configuring the first assembled battery 2a' is greater than the capacity of the cells α.

As described above, with the power supply system 50 of this embodiment, preferably, when using a nonaqueous electrolyte secondary battery as the cell α, the forced discharge start voltage Va is provided so that the cell α will be near 4.0V per cell (that is, the forced discharge start voltage Va is an integral multiple of 4.0V).

If a multi-purpose generator based on a lead storage battery specification is to be used as the generator 1, the rated voltage is 14.5V, and there is a problem in that it will not be an integral multiple of 4.0V, and a fraction (2.5V) will arise. Thus, the foregoing fraction can be dealt with by additionally connecting in series, as needed, a cell γ (alkaline storage battery in which the average charging voltage is near 1.4V) to a plurality of cells α (first assembled battery 2a) that are connected in series.

Specifically, as described above, when using as the first assembled battery 2a' configured by additionally connecting in series two nickel hydride storage batteries having an average charging voltage of 1.4V as the cells γ to three lithium ion secondary batteries connected in series and having an average charging voltage of 3.8V as the cells α, the average charging voltage V1 of the first assembled battery 2a' will be 14.2V. Here, the nickel hydride storage battery as the cell γ has a highly flat charging voltage (change of the terminal voltage in relation to the change of SOC is small). Specifically, in the case of a nickel hydride storage battery, the charging voltage will remain flat and hardly change even if the SOC rises due to the charge. Meanwhile, with a lithium ion storage battery, since the charging voltage will rise pursuant to the rise of the SOC due to the charge, the cell α (lithium ion secondary battery) will be charged to a predetermined voltage (3.9V).

Thus, if the capacity of the cell γ is set to be greater than the capacity of the cell α, the foregoing flatness of the nickel hydride storage battery (charging voltage is flat and will hardly change during the charge regardless of the SOC) can be used to distribute the remaining 0.3V (value obtained by subtracting 14.2V as the average charging voltage V1 of the first assembled battery 2a from 14.5V as the rated voltage of the generator 1) to the charge of the three cells α. Consequently, the cells α (lithium ion secondary batteries) can be charged up to 3.9V per cell (73% based on SOC conversion).

As the cell assembly 20', in the foregoing configuration comprising the cell γ, preferably, if the number of the cell α in the first assembled battery 2a is n_{A} and the number of the cell γ is n_{C}, the upper limit voltage Va is set within the range of (4.05n_{A} + 1.4n_{C})V or more and (4.15n_{A} + 1.4n_{C})V or less.

As described above, the first assembled battery 2a can be suitably combined to match the rated voltage of the generator 1 so as to enable the charge without excess or deficiency. Thus, if the range of the upper limit voltage Va is set to the foregoing range, the reason why the foregoing range is preferable is because, while this is the same as the configuration of not comprising the cells γ, it is possible to avoid the danger when the charging voltage of the cells α or the cells γ configuring the first assembled battery 2a becomes abnormally high.

Moreover, as in the foregoing example, preferably, an alkaline storage battery (specifically, a nickel hydride storage battery having an average charging voltage of 1.4V per cell) is used as the cells β configuring the second assembled battery 2b,

Since an alkaline storage battery entails a rise in temperature simultaneously with the completion of full charge as the characteristic of nickel hydroxide as the positive electrode active material, the oxygen overvoltage will drop and the charging voltage will also drop. However, according to the configuration of this embodiment in which a lateral flow circuit is used as the second assembled battery 2b in substitute for a resistor with significant heat generation, it is possible to prevent the problem of the cell deforming due to the rise in the atmospheric temperature of the cell assembly 20 (particularly the first assembled battery 2a as the primary power source). Thus, an alkaline storage battery can be used, without any problem, as the cell β with high energy density per unit weight configuring the second assembled battery 2b as the lateral flow circuit.

As described above, the power supply system according to one aspect of the present invention has: a cell assembly in which a first assembled battery, formed from a plurality of first cells connected in series, and a second assembled battery, formed from a plurality of second cells connected in series, are connected in parallel; and a generator for charging the cell assembly. The cell assembly is configured such that an average charging voltage V1 as a terminal voltage, when the first assembled battery reaches a charging capacity that is half of a full charge capacity, is set to be a voltage that is smaller than an average charging voltage V2 as a terminal voltage, when the second assembled battery reaches a charging capacity that is half of a full charge capacity.

According to the foregoing configuration, the present invention includes a cell assembly in which two types of assembled batterires, a first assembled battery, formed from a plurality of first cells connected in series, and a second assembled battery, formed from a plurality of second cells connected in series, are connected in parallel and an average charging voltage V1 of the first assembled battery is set to be a voltage that is smaller than an average charging voltage V2 of the second assembled battery. Thereby, in a normal state (until reaching the forced discharge start voltage that is set to be slightly lower than the full charge voltage), the first assembled battery mainly receives the charging current from the generator, and, when the first assembled battery approaches full charge, the second assembled battery as the lateral flow circuit receives the charging current from the generator. According to this mode, since a resistor which is associated with excessive heat generation is not used, the atmospheric temperature of the cell assembly (particularly the first assembled battery as the primary power source) will not increase. Thus, it is possible to avoid the problem of the cell deforming due to heat.

Accordingly, even when using an alkaline storage battery such as a nickel hydride storage battery or a nickel cadmium storage battery or a nonaqueous electrolyte secondary battery such as a lithium ion secondary battery or a lithium polymer secondary battery with high energy density per unit weight as the secondary battery, it is possible to realize a safe and secure power supply system capable of receiving all currents from the generator as a charging current without inducing problems such as the deformation of the secondary battery.

In the foregoing configuration, the configuration may additionally comprise a voltage measurement unit for measuring a voltage of the first assembled battery, and a control unit for controlling a voltage of the cell assembly based on a measurement result of the voltage measurement unit, and the control unit may perform control so as to stop the charge to the first assembled battery when the voltage of the first assembled battery measured with the voltage measurement unit reaches an upper limit voltage Va.

In the foregoing configuration, the voltage measurement unit may measure a voltage of the respective first cells configuring the first assembled battery, and the control unit may perform control so as to stop the charge to the first assembled battery when a voltage of any of the first cells configuring the first assembled battery measured by the voltage measurement unit reaches an upper limit voltage Va.

The foregoing configuration is preferable since it is possible to deal with the variation in the capacity of the respective first cells configuring the first assembled battery caused by, for instance, the variation in the weight of the positive electrode active material or degree of deterioration caused by the difference in the temperature history.

In the foregoing configuration, the configuration may further comprise a switch for switching ON/OFF a connection between the generator and the first assembled battery, and the control unit may control the switch to turn OFF the connection when a voltage of the first assembled battery measured by the voltage measurement unit reaches an upper limit voltage Va.

In the foregoing configuration, wherein the voltage measurement unit may measure a voltage of the respective first cells configuring the first assembled battery, and the control unit may control the switch to turn OFF the connection when a voltage of any of the first cells configuring the first assembled battery measured by the voltage measurement unit reaches an upper limit voltage Va.

In the foregoing configuration, preferably, a ratio V2/V1 of an average charging voltage V1 of the first assembled battery 2a to an average charging voltage V2 of the second assembled battery 2b is set within the range of 1.01 or more and 1.18 or less.

This is because, if the ratio V2/V1 is less than 1.01, the charging current from the generator 1 will easily flow to the second assembled battery, and the first assembled battery cannot be efficiently charged. Contrarily, if the ratio V2/V1 exceeds 1.18, the first assembled battery will easily overcharge.

Preferably, a nonaqueous electrolyte secondary battery such as a lithium ion secondary battery is used as the first cell configuring the first assembled battery as with the present embodiment.

This is because the nonaqueous electrolyte secondary battery has high energy density in comparison to an alkaline storage battery, and is preferable as the receiving end of the charging current in the power supply system. Although a nonaqueous electrolyte secondary battery entails problems such as the electrolyte component decomposing under a high temperature environment, as a result of adopting the configuration of this embodiment in which a lateral flow circuit is used as the second assembled battery in substitute for a resistor with significant heat generation, it is possible to prevent the problem of the cell deforming due to the rise in the atmospheric temperature of the cell assembly (particularly the first assembled battery as the primary power source). Thus, a nonaqueous electrolyte secondary battery with high energy density per unit weight can be used, without any problem, as the first cells configuring the first assembled battery.

If a nonaqueous electrolyte secondary battery is used as the first cell, preferably, lithium composite oxide containing cobalt is used as an active material of a positive electrode of the nonaqueous electrolyte secondary battery. This is because the discharge voltage of the nonaqueous electrolyte secondary battery can be increased as a result of using lithium composite oxide containing cobalt such as lithium cobalt oxide as the active material of the positive electrode, and the energy density can be easily increased.

Moreover, preferably, when the number of cells α in the first assembled battery is n_{A}, the upper limit voltage Va of the first assembled battery is set within the range of 4.05n_{A}V or more and 4.15n_{A}V or less. This is because if the upper limit voltage Va is set to less than 4.05n_{A}V, the amount of charge acceptance of the first assembled battery will be insufficient. Contrarily, if the upper limit voltage Va is set in excess of 4.15n_{A}V, the forced discharge of the first assembled battery will not start until approaching the overcharge range of the first cells.

In the foregoing configuration, preferably, the first assembled battery is configured in which a third cell of an alkaline storage battery is further connected in series to a plurality of first cells connected in series. Moreover, preferably, the capacity of the third cell is larger than the capacity of the first cell.

If the power supply system of the present invention uses a nonaqueous electrolyte secondary battery as the first cell, preferably, the forced discharge start voltage Va is provided so that the first cell will be near 4.0V per cell (that is, the forced discharge start voltage Va is an integral multiple of 4.0V).

Here, if a multi-purpose generator based on a lead storage battery specification is to be used as the generator, the rated voltage is 14.5V, and there is a problem in that it will not be an integral multiple of 4.0V, and a fraction (2.5V) will arise. Thus, the foregoing fraction can be dealt with by additionally connecting in series, as needed, a third cell (alkaline storage battery in which the average charging voltage is near 1.4V) to a plurality of first cells that are connected in series.

For example, when using as a first assembled battery configured by additionally connecting in series two nickel hydride storage batteries having an average charging voltage of 1.4V as the cells γ to three lithium ion secondary batteries connected in series and having an average charging voltage of 3.8V as the cells α, the average charging voltage V1 of the first assembled battery will be 14.2V. Here, the nickel hydride storage battery as the third cell has a highly flat charging voltage (change of the terminal voltage in relation to the change of SOC is small). Specifically, in the case of a nickel hydride storage battery, the charging voltage will remain flat and hardly change even if the SOC rises due to the charge. Meanwhile, with a lithium ion storage battery, since the charging voltage will rise pursuant to the rise of the SOC due to the charge, the first cell (lithium ion secondary battery) will be charged to a predetermined voltage (3.9V).

Thus, if the capacity of the third cell is set to be greater than the capacity of the first cell, the foregoing flatness of the nickel hydride storage battery (charging voltage is flat and will hardly change during the charge regardless of the SOC) can be used to distribute the remaining 0.3V (value obtained by subtracting 14.2V as the average charging voltage V1 of the first assembled battery 2a from 14.5V as the rated voltage of the generator 1) to the charge of the three first cells. Consequently, the first cells (lithium ion secondary batteries) can be charged up to 3.9V per cell (73% based on SOC conversion).

In the foregoing configuration, preferably, when the number of the first cells in the first assembled battery is n_{A} and the number of the third cells is n_{C}, the forced discharge start voltage Va is set within the range of (4.05n_{A} + 1.4n_{C})V or more and (4.15n_{A} + 1.4n_{C})V or less.

According to the foregoing configuration, the first assembled battery can be suitably combined to match the rated voltage of the generator so as to enable the charge without excess or deficiency. Thus, if the range of the forced discharge start voltage Va is set to the foregoing range, the reason why the foregoing range is preferably is because, while this is the same as the configuration of not comprising a third cell, it is possible to avoid the danger when the charging voltage of the first cells or the third cells configuring the first assembled battery becomes abnormally high. Moreover, sufficient safety can be ensured without having to measure and control the individual voltages of the first assembled battery.

In the foregoing configuration, preferably, an alkaline storage battery (specifically, a nickel hydride storage battery having an average charging voltage of 1.4V per cell) is used as the second cell configuring the second assembled battery.

Since an alkaline storage battery entails a rise in temperature simultaneously with the completion of full charge as the characteristic of nickel hydroxide as the positive electrode active material, the oxygen overvoltage will drop and the charging voltage will also drop. However, according to the configuration of this invention in which a lateral flow circuit is used as the second assembled battery in substitute for a resistor with significant heat generation, it is possible to prevent the problem of the cell deforming due to the rise in the atmospheric temperature of the cell assembly. Thus, an alkaline storage battery with high energy density per unit weight can be used, without any problem, as the second cell configuring the second assembled battery as the lateral flow circuit.

A control method of a cell assembly according to another aspect of the present invention is a method of controlling a cell assembly in which a first assembled battery, formed from a plurality of first cells connected in series, and a second assembled battery, formed from a plurality of second cells connected in series, are connected in parallel, and an average charging voltage V1 of the first assembled battery is set to be a voltage that is smaller than an average charging voltage V2 of the second assembled battery, the method comprising: a step (a) of measuring a voltage of the first assembled battery; and a step (b) of controlling so as to stop the charge to the first assembled battery when the voltage of the first assembled battery measured in the step (a) reaches an upper limit voltage Va.

In the foregoing method, preferably, in the step (b), a switch for switching ON/OFF the connection between the generator and the first assembled battery is used to perform control to turn OFF the connection when a voltage of the first assembled battery measured in the step (a) reaches the upper limit voltage Va.

In the foregoing method, preferably, the step (a) includes a step of measuring a voltage of the respective cells A configuring the first assembled battery, and control is performed to stop the charge to the first assembled battery when a voltage of any of the first cells configuring the first assembled battery measured by the voltage measurement unit reaches the upper limit temperature Va.

In the foregoing method, preferably, a ratio V2/V1 of an average charging voltage V1 to an average charging voltage V2 is set within the range of 1.01 or more and 1.18 or less.

In the foregoing method, preferably, a nonaqueous electrolyte secondary battery is used as the first cell. Moreover, preferably, lithium composite oxide containing cobalt is used as an active material of a positive electrode of the nonaqueous electrolyte secondary battery.

In the foregoing method, preferably, when the number of the first cells configuring the first assembled battery is n_{A}, the upper limit voltage Va is set within the range of 4.05n_{A}V or more and 4.15n_{A}V or less.

In the foregoing method, preferably, as the first assembled battery, an assembled battery in which a third cell of an alkaline storage battery is further connected in series to the first assembled battery to first cells connected in series is used. In the foregoing method, preferably, the capacity of the third cell is larger than the capacity of the first cell.

In the foregoing method, preferably, when the number of the first cells in the first assembled battery is n_{A} and the number of the third cells is n_{C}, the upper limit voltage Va is set within the range of (4.05n_{A} + 1.4n_{C})V or more and (4.15n_{A} + 1.4n_{C})V or less.

In the foregoing method, preferably, an alkaline storage battery is used as the second cell.

According to the respective configurations of the present invention described above, the same effects as the configuration of the respective power supply systems of the present invention described above can be yielded.

Although the foregoing example used a lithium ion secondary battery as the first cell (cell α), similar results can be obtained even when using a lithium polymer secondary battery among the nonaqueous electrolyte secondary batteries in which the electrolyte is in the form of a gel. Moreover, although the foregoing example used a nickel hydride storage battery as the first cell, similar results were obtained when using a nickel cadmium storage battery or the like.

### Industrial Applicability

Since the power supply system of the present invention uses an assembled battery made up of nonaqueous electrolyte secondary batteries with a higher energy density per unit weight than lead storage batteries, the application potency of the present invention as a cell starter power supply of racing cars is high, and extremely effective.

## Claims

1. A power supply system, comprising:
a cell assembly in which a first assembled battery, formed from a plurality of first cells connected in series, and a second assembled battery, formed from a plurality of second cells connected in series, are connected in parallel; and
a generator for charging the cell assembly, wherein
the cell assembly is configured such that an average charging voltage V1 as a terminal voltage, when the first assembled battery reaches a charging capacity that is half of a full charge capacity, is set to be a voltage that is smaller than an average charging voltage V2 as a terminal voltage, when the second assembled battery reaches a charging capacity that is half of a full charge capacity.

2. The power supply system according to claim 1, comprising:
a voltage measurement unit for measuring a voltage of the first assembled battery;
and
a control unit for controlling a voltage of the cell assembly based on a measurement result of the voltage measurement unit, wherein
the control unit performs control so as to stop the charge to the first assembled battery when the voltage of the first assembled battery measured by the voltage measurement unit reaches an upper limit voltage Va.

3. The power supply system according to claim 2, wherein
the voltage measurement unit measures a voltage of the respective first cells configuring the first assembled battery, and
the control unit performs control so as to stop the charge to the first assembled battery when a voltage of any of the first cells configuring the first assembled battery measured by the voltage measurement unit reaches an upper limit voltage Va.

4. The power supply system according to claim 3, further comprising a switch for switching ON/OFF a connection between the generator and the first assembled battery, wherein
the control unit controls the switch to turn OFF the connection when a voltage of the first assembled battery measured by the voltage measurement unit reaches an upper limit voltage Va.

5. The power supply system according to claim 4, wherein
the voltage measurement unit measures a voltage of the respective first cells configuring the first assembled battery, and
the control unit controls the switch to turn OFF the connection when a voltage of any of the first cells configuring the first assembled battery measured by the voltage measurement unit reaches an upper limit voltage Va.

6. The power supply system according to any one of claims 1 to 5,
wherein a ratio V2/V1 of an average charging voltage V1 of the first assembled battery to an average charging voltage V2 of the second assembled battery is set within a range of 1.01 or more and 1.18 or less.

7. The power supply system according to any one of claims 1 to 6, wherein the first cell is a nonaqueous electrolyte secondary battery.

8. The power supply system according to claim 7, wherein lithium composite oxide containing cobalt is used as an active material of a positive electrode of the nonaqueous electrolyte secondary battery.

9. The power supply system according to claim 7 or claim 8, wherein, when the number of the first cells in the first assembled battery is n_{A}, the forced discharge start voltage Va is set within a range of 4.05n_{A}V or more and 4.15n_{A}V or less.

10. The power supply system according to any one of claims 1 to 8, wherein the first assembled battery is configured in which a third cell of an alkaline storage battery is further connected in series to a plurality of first cells connected in series.

11. The power supply system according to claim 10, wherein a capacity of the third cell is larger than a capacity of the first cell.

12. The power supply system according to claim 10, wherein, when the number of the first cells in the first assembled battery is n_{A} and the number of the third cells is n_{C}, the upper limit voltage Va is set within a range of (4.05n_{A} + 1.4n_{C})V or more and (4.15n_{A} + 1.4n_{C})V or less.

13. The power supply system according to any one of claims 1 to 12, wherein an alkaline storage battery is used as the second cell.

14. A method of controlling a cell assembly in which a first assembled battery, formed from a plurality of first cells connected in series, and a second assembled battery, formed from a plurality of second cells connected in series, are connected in parallel, and an average charging voltage V1 of the first assembled battery is set to be a voltage that is smaller than an average charging voltage V2 of the second assembled battery,
the method comprising:
a step (a) of measuring a voltage of the first assembled battery; and
a step (b) of controlling to stop the charge to the first assembled battery when the voltage of the first assembled battery measured in the step (a) reaches an upper limit voltage Va.

15. The method of controlling a cell assembly according to claim 14, wherein, in the step (b), a switch for switching ON/OFF a connection between a generator and the first assembled battery is used to perform control to turn OFF the connection when a voltage of the first assembled battery measured in the step (a) reaches the upper limit voltage Va.

16. The method of controlling a cell assembly according to claim 15, wherein
the step (a) includes a step of measuring a voltage of the respective cells A configuring the first assembled battery, and
control is performed to stop the charge to the first assembled battery when a voltage of any of the first cells configuring the first assembled battery measured by the voltage measurement unit reaches the upper limit temperature Va.

17. The method of controlling a cell assembly according to any one of claims 14 to 16, wherein a ratio V2/V1 of the average charging voltage V1 and the average charging voltage V2 is set within a range of 1.01 or more and 1.18 or less.

18. The method of controlling a cell assembly according to any one of claims 13 to 17, wherein a nonaqueous electrolyte secondary battery is used as the first cell.

19. The method of controlling a cell assembly according to claim 18, wherein lithium composite oxide containing cobalt is used as an active material of a positive electrode of the nonaqueous electrolyte secondary battery.

20. The method of controlling a cell assembly according to claim 18 or claim 19, wherein, when the number of the first cells configuring the first assembled battery is n_{A}, the upper limit voltage Va is set within a range of 4.05n_{A}V or more and 4.15n_{A}V or less.

21. The method of controlling a cell assembly according to any one of claims 18 to 20, wherein the first assembled battery is configured in which a third cell of an alkaline storage battery being additionally connected in series to a plurality of first cells connected in series.

22. The method of controlling a cell assembly according to claim 21, wherein the third cell having a capacity larger than a capacity of the first cell is used.

23. The method of controlling a cell assembly according to claim 22, wherein, when the number of the first cells in the first assembled battery is n_{A} and the number of the third cells is n_{C}, the upper limit voltage Va is set within a range of (4.05n_{A} + 1.4n_{C})V or more and (4.15n_{A} + 1.4n_{C})V or less.

24. The method of controlling a cell assembly according to any one of claims 14 to 23, wherein an alkaline storage battery is used as the second cell.
